# EUROPEAN PATENT SPECIFICATION

(11) **EP 2 840 596 B1**
(45) Date of publication and mention of the grant of the patent: **22.11.2017**
(21) Application number: 12874866.2
(22) Date of filing: 17.04.2012
(51) Int. Cl.: H05K 3/34, H01L 21/48, B23K 37/06

(54) **FORMING METHOD OF SOLDER BUMPS AND MANUFACTURING METHOD FOR SUBSTRATE HAVING SOLDER BUMPS**
VERFAHREN ZUR HERSTELLUNG VON LÖTHÖCKERN UND VERFAHREN ZUR HERSTELLUNG EINES SUBSTRATS MIT LÖTHÖCKERN
PROCÉDÉ DE FORMATION DES BOSSAGES DE SOUDURE ET PROCÉDÉ DE FABRICATION POUR UN SUBSTRAT AYANT DES BOSSAGES DE SOUDURE

(43) Date of publication of application: 25.02.2015
(73) Proprietor: Tanigurogumi Corporation, Nasushiobara City Tochigi 329-2921 (JP)
(72) Inventor: TANIGURO, Katsumori, Nasushiobara-shi, Tochigi 329-2921 (JP)
(74) Representative: Klunker IP Patentanwälte PartG mbB
(86) International application number: PCT/JP2012/060301
(87) International publication number: WO 2013/157075

(56) References cited:
- WO-A1-2011/018861
- JP-A- H0 864 943
- JP-A- H04 234 195
- JP-A- H06 177 527
- JP-A- 2001 044 231
- JP-A- 2001 203 444
- JP-A- 2002 514 352
- JP-A- 2011 236 457
- US-A- 3 298 588
- US-A- 5 964 395
- US-A1- 2011 079 633

## Description

### Field of the Invention

The present invention relates to a method for forming solder bumps and a method for manufacturing a mounting substrate. More particularly, the invention relates to a method for forming solder bumps having a constant thickness capable of preventing corrosion of copper forming a copper electrode on the copper electrode of a substrate such as a printed circuit board, a wafer, or a flexible substrate.

### Background Art

Recent years have seen increasing improvement in wiring density and mounting density on substrates such as printed circuit boards, wafers, and flexible substrates (which may be hereinafter referred to as "mounting substrates"). Solder bumps used for soldering electronic components on a mounting substrate are required to be minute and uniform in shape, size, and the like. As a solder bump forming method satisfying such requirements, Patent Document 1 has proposed a technique and the like for easily forming bumps dense and constant in shape by using a screen plate provided with openings for forming paste bumps with a paste and characterized in that the plate includes a rigid first metal layer, a resin-based adhesive layer, and a second metal layer and the openings of the adhesive layer and the second layer have smaller diameters than that of the openings of the first metal layer.

Meanwhile, in electronic components such as a connector, a QFP (Quad Flat Package), a SOP (Small Outline Package), and a BGA (Ball Grid Array), there may be dimensional variations in connection terminals such as lead terminals. In order to solder electronic components with such connection terminals having varied dimensions without soldering failure, it is necessary to reduce influence of the dimensional variations on the electronic components by increasing thickness of solder bumps formed on a mounting substrate. Accordingly, a metal mask such as the screen plate used in Patent Document 1 needs to be thick enough to allow a considerable amount of solder to be provided on the mounting substrate.

On the other hand, when small electronic components such as a CSP (Chip Size Package) are among electronic components mounted on a mounting substrate, the sizes of solder bumps for such small electronic components are very minute. Thus, a metal mask used to form the solder bumps on the mounting substrate is provided with small openings for small electronic components. Meanwhile, the metal mask for providing the considerable amount of solder has a thickness enough to absorb the dimensional variations of connection terminals. Openings for small electronic components provided in the metal mask having such a thickness have a large aspect ratio (thickness/opening width). When a solder paste is screen printed using the metal mask, the solder paste remains on the metal mask and thus the thickness of the solder paste becomes unstable. In order to solve the problem, it is necessary to appropriately form a plurality of solder bumps having different height directions (thicknesses) so that electronic components having connection terminals having large dimensional variations and small electronic components can be simultaneously mounted on the same mounting substrate. However, manufacturing of a plurality of bumps having different thicknesses is a complicated task and therefore not preferable in terms of manufacturing cost.

Patent Document 2 has proposed a method for forming solder bumps suitable for both of large electronic components such as a connector, a QFP, a SOP, and a BGA and small electronic components such as a CSP even when the large and small electronic components are mounted together. In the method, a solder print mask including a first metal layer with openings and a second layer with other openings is arranged on a printed circuit board with electrodes (mounting substrate) such that the second layer closely contacts with the printed circuit board, then a solder paste is supplied from the first layer side and squeegeed by a squeegee jig to form solder bumps having different heights.

In addition, there is another known solder bump forming method, in which a mounting substrate provided with a copper electrode is directly dipped (immersed) in molten solder. However, when the mounting substrate is directly dipped in molten solder, tin included in the solder corrodes copper of the copper electrode to cause a so-called "copper corrosion", leading to disappearance of the copper pattern. Accordingly, a method has been considered in which, in order to shorten a time for dipping a mounting substrate in molten solder to suppress copper corrosion, a preliminary solder layer is formed on a copper electrode of the mounting substrate and then the mounting substrate is dipped in the molten solder (a dipping method).
Patent Document 3 discloses a spray soldering machine for soldering printed circuit boards which comprises a container for storing liquid solder, means for spraying liquid solder, means for storing blast-off liquid, means for spraying blast-off liquid disposed within the container. The spray soldering machine is capable of efficiently blasting-off excess solder and forming smooth and even deposition of solder.
Patent Document 4 discloses a tin or solder alloy film which is formed by ejecting molten tin liquid or molten solder alloy liquid in a jet state onto a copper surface of an electronic component. The overflowing molten tin or molten solder alloy liquid is transported to a stirrer. Then, cuprate and the like mixed in the overflowing molten tin or molten solder alloy liquid are taken in to an organic fatty acid solution by fiercely stirring and mixing the molten tin or molten solder alloy liquid in contact with a solution at a temperature of 180 to 350 °C. The organic fatty acid contains 1 to 80 weight % of organic fatty acid having 12 to 20 carbon atoms and is circulated in the stirrer to purify the overflowing molten tin or molten solder alloy liquid. The mixed solution then is introduced into a reservoir of the organic fatty acid solution, and the purified molten tin solution or molten solder alloy liquid separated according to the specific gravity difference in the reservoir of the organic fatty acid solution is returned from the bottom of the organic fatty acid solution reservoir to the reservoir of the molten tin or molten solder liquid by a pump for circulation use. By means of this, copper is prevented from accumulating in the molten tin or molten solder liquid, and thus it is possible to continuously perform a stable soldering process for a long term.
Patent Document 5 discloses a method for forming a solder coat on an electrode pad or a lead of an electronic circuit board or an electronic component connector, wherein a tin or solder precoat film is formed on the electrode pad or the lead by a first step and a second step. In the first step, the electronic circuit board or the electronic component connector, wherein the surface which is not covered by the electrode pad or the lead is protected by a solder resist film and only the electrode pad or the lead is exposed, is brought into contact with a high-temperature organic fatty acid solution, so that an oxidized layer on the surface of the electrode pad or the lead is removed to clean the surface by the chemical action of the organic fatty acid, and a protection coat made of an organic fatty acid is formed on the cleaned surface of the pad or the lead and, thereafter, the electronic circuit board or the electronic component connector is brought into contact with a molten tin liquid or a molten solder liquid to form a tin or solder bonding coat on the pad or the lead. In the second step, the high-temperature organic fatty acid solution is sprayed onto the pad or the lead of the electronic circuit board or the electronic component connector, to remove the excessive tin or solder.
Patent Document 6 teaches a method of attaching an electronic component to a substrate comprising the steps of depositing a spray metal coating atop a substrate. An electronic component is placed atop a coating. A liquid metal is dispensed on or near the component. The liquid metal wets the component and the coating. The metal is reacted with the coating to form an electrically conductive bond with the substrate and adheres the component to the substrate. The reactive metal may be heated to a temperature which makes it liquid and facilitates wetting the coating and component. Suitable materials for the spray metal coating include copper, nickel, tin, bismuth, lead and silver and mixtures thereof. Suitable liquid metals generally include low melting temperature metals such as gallium and indium and mixtures thereof.
Patent Document 7 discloses a printed wiring board which is able to cope with subminiaturization and which is free from connection failures caused by positional deviation and positional troubles such as solder bridges when a surface-mounting type part is soldered to the board. Accordingly, a surface mounting printed wiring board is formed through such a manner that a mask provided with an opening at a prescribed position is arranged on a surface-mounting type part mounting pad on an insulating board, then molten solder is sprayed on the masked insulating board from a nozzle installed properly distant from the insulating board to form a solder layer on the mounting pad.

### Prior Art References

### Patent Documents

Patent Document 1: Japanese Laid-Open Patent Application No. H10-286936
Patent Document 2: Japanese Laid-Open Patent Application No. 2006-66811
Patent Document 3: US 3,298,588 A
Patent Document 4: US 2011/079633 A1
Patent Document 5: WO 2011/018861 A1
Patent Document 6: US 5,964,395 A
Patent Document 7: JP H06 177527 A

### Summary of the Invention

### Problems to be Solved by the Invention

However, the method of Patent Document 2 has a problem in that it is a method for forming solder bumps having different heights by squeegeeing the supplied solder paste with a squeegee jig, thus leading to low productivity. Additionally, the dipping method described above is problematic in that the problem of copper corrosion still remains unsolved.

The present invention has been accomplished to solve the above problems. It is an object of the invention to provide a method for forming a solder bump in which solder bumps having a desired constant thickness can be formed without problems such as copper corrosion on a substrate with a minute electrode, such as a printed circuit board, a wafer, or a flexible substrate. It is another object of the invention to provide a method for manufacturing a substrate provided with such a solder bump.

### Means for Solving the Problems

The present invention is defined in the appended claims. In order to solve the problems described above, the method for forming the solder bump includes: preparing a substrate that has a copper electrode, whereby on the copper electrode only portions for mounting electronic components are exposed, whereas other portions of the substrate are covered with an insulation layer or an insulation film, preparing a mask from a layer of heat-resistant material, the layer being provided with an opening portion, the mask having a thickness in the range of from 20 to 500 µm, and subsequently overlapping the mask and the substrate by matching and superimposing the position of the opening portion in the mask with the position of the copper electrode;
piling up a molten solder by spraying a jet stream of the molten solder at a temperature of not less than 150 °C and not more than 300 °C, wherein the substrate is held in a horizontal position during spraying and the jet stream of the molten solder is sprayed from above until a thickness of the molten solder is greater than a thickness of the mask, wherein the molten solder is purified by a refining process, forming the solder bumps having the predetermined thickness by removing an excess of the molten solder that is piled up beyond the thickness of the mask, and removing the mask from the overlapped substrate, wherein an atmosphere temperature during processing in both the step of piling up the molten solder and the step of forming the solder bumps by removing the excess of the molten solder is maintained at a temperature that can keep the molten state of molten solder as it is, the refining process is performed by stirring and mixing the molten solder with a solution including 5 % to 25 % by mass of organic fatty acid and having 12 to 20 carbon atoms and being heated to a temperature of from 180 °C to 350 °C, the molten solder is molten lead-free solder that includes tin as a main component and at least nickel as an accessory component, and further includes one or more components selected from among silver, copper, zinc, bismuth, antimony and germanium as an optional accessory component, and removing the excess of the molten solder piled up beyond the thickness of the mask is performed by a removal unit, selected from a group consisting of a blade, an air cutter, and a removal unit spraying organic fatty acid-containing solution having 12 to 20 carbon atoms.

According to the present invention, the jet stream of the molten solder including tin as the main ingredient and at least nickel as the accessory ingredient is sprayed to the opening portion, whereby the Cu-Ni-Sn intermetallic compound layer obtained by alloying of the copper of the copper electrode and the nickel included in the molten solder is formed on a surface of the copper electrode. The intermetallic compound layer formed on the surface of the copper electrode serves as a barrier layer against copper corrosion. Since the barrier layer prevents copper corrosion of the copper electrode, defects and disappearance of the copper electrode caused by copper corrosion can be prevented. As a result, reliability can be ensured in the copper electrodes such as a copper land of the mounting substrate. Thus, when electronic components are soldered to a mounting substrate, copper corrosion occurring in conventional soldering can be suppressed. In addition, according to the invention, the removal of molten solder exceeding the thickness of the mask is performed by a simple means, that is, a removing means such as a blade or an air cutter or a removing means that sprays an organic fatty acid-containing solution having from 12 to 20 carbon atoms. Thus, solder bumps having a desired constant thickness can be easily formed with high dimensional precision on the mounting substrate with the minute copper electrode. As a result, such a high-cost step as in the conventional art is unnecessary, thus allowing for increase in reliability and yield of joints at which electronic components are solder-bonded to the solder bumps. This is advantageous in terms of manufacturing a low-cost mounting substrate.

In the forming method of solder bumps, a coating film having organic fatty acid in the organic fatty acid-containing solution is formed on the solder bumps.

In the forming method of solder bumps, contacting the organic fatty acid-containing solution to the copper electrode before by spraying a jet stream of the molten solder to the copper electrode.

In the forming method of solder bumps, the organic fatty acid-containing solution is solution including palmitic acid having 16 atoms.

In order to solve the problems described above, the method for manufacturing a mounting substrate includes: forming solder bumps on a surface of the copper electrode by the forming method of solder bumps according to the present invention; and mounting an electronic component by soldering on the formed solder bumps.

According to the present invention, since the solder bump is formed by the solder bump forming method described above, reliability can be ensured in the copper electrode such as a copper land of the mounting substrate, and when electronic components are soldered to the mounting substrate, copper corrosion occurring in conventional soldering can be suppressed. In addition, the solder bumps having a desired constant thickness can be easily formed with high dimensional precision on the mounting substrate with the minute copper electrode. In the invention described above, such a high-cost step as in the conventional art is unnecessary, thus allowing for increase in reliability and yield of joint portions at which electronic components are solder-bonded to the solder bumps, so that a low-cost mounting substrate can be manufactured.

### Effect of the Invention

The solder bump forming method according to the present invention allows for the formation of a Cu-Ni-Sn intermetallic compound layer obtained by alloying of copper of the copper electrode and nickel included in the molten solder on a surface of the copper electrode. Thus, the intermetallic compound layer serves as a barrier layer against copper corrosion, and the barrier layer can prevent copper corrosion of the copper electrode, thereby allowing for the prevention of defects and disappearance of the copper electrode due to copper corrosion. As a result, reliability can be ensured in the copper electrode such as a copper land of the mounting substrate. Thus, when electronic components are soldered to a mounting substrate, copper corrosion occurring in conventional soldering can be suppressed. In addition, the present invention allows solder bumps having a desired constant thickness to be easily formed with high dimensional precision on a mounting substrate with a minute copper electrode. Thus, such a high-cost step as in the conventional art is unnecessary, thus allowing for increase in reliability and yield of joint portions at which electronic components are solder-bonded to the solder bumps. This is advantageous in terms of manufacturing a low-cost mounting substrate.

The mounting substrate manufacturing method according to the present invention can ensure reliability of a copper electrode such as a copper land of a mounting substrate and can suppress copper corrosion occurring in conventional soldering when electronic component are soldered to a mounting substrate. In addition, the manufacturing method allows solder bumps having a desired constant thickness to be easily formed with high dimensional precision on a mounting substrate with a minute copper electrode thereon. As a result, such a high-cost step as in the conventional art is unnecessary, thus allowing for increase in reliability and yield of joint portions at which electronic components are solder-bonded to the solder bumps, so that a low-cost mounting substrate can be manufactured.

### Brief Descriptions of the Drawings

Fig. 1 is a schematic perspective view depicting a substrate and a mask used in a solder bump forming method according to the present invention.
Figs. 2 are step diagrams (1) depicting one example of the solder bump forming method according to the invention.
Figs. 3 are step diagrams (2) depicting the one example of the solder bump forming method according to the invention.
Figs. 4 are a part of step diagrams depicting another example of the solder bump forming method according to the invention.
Figs. 5 are examples using masks having different shapes.
Figs. 6 are examples of intermetallic compound layers formed on copper electrodes, in which Fig. 6(A) is a schematic diagram of a sectional shape of a solder joint portion formed in a Comparative Example and Fig. 6(B) is a schematic diagram of a sectional shape of a solder joint portion formed in an Example.
Fig. 7 is a wettability (meniscograph) test result of a molten solder purified with an organic fatty acid-containing solution.
Fig. 8 is a wettability (meniscograph) test result of an unpurified molten solder.
Fig. 9 is a graph depicting the amounts of oxygen in the depth directions of solder layers.
Figs. 10 are examples as to whether a micro void occurs after heating a solder joint portion, in which Figs. 10(A) and 10(B) are results of the Comparative Example and Figs. 10(C) and 10(D) are results of the Example.
Figs. 11 are element-mapping images of the solder joint portion obtained in the Example.

### Embodiments of the Invention

Hereinafter, a description will be given of a solder bump forming method and a method for manufacturing a mounting substrate according to the present invention, with reference to the drawings. In the present application, the term "the present invention" can be rephrased as "embodiment of the present application".

### [Solder Bump Forming Method]

A method for forming solder bump 11 according to the present invention includes a step of preparing substrate 1 on which copper electrode 2 is formed, a step of preparing mask 5 on which opening 6 for forming solder bump 11 at a necessary position on copper electrode 2 is formed, a step of superimposing substrate 1 and mask 5 and then spraying jet stream 11' of molten solder from a surface S1 side of mask 5 to deposit molten solder 11a on opening portion 6 of mask 5 until a thickness of molten solder 11a becomes larger than a thickness of mask 5, a step of removing molten solder 11a exceeding the thickness of mask 5 to form solder bump 11 having a predetermined thickness, and a step of removing mask 5.

Each of the steps will be described in detail below.

### (Substrate Preparation Step)

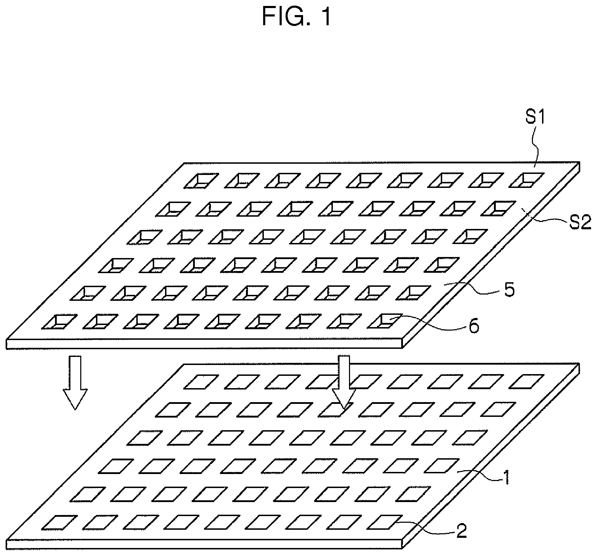

Substrate 1 prepared is a substrate such as a printed circuit board, a wafer, or flexible substrate, as depicted in Fig. 1. On such substrate 1 is formed predetermined copper electrode 2. Preferably, copper electrode 2 may be a narrow-pitch electrode having a pattern width of 5 µm or more or 10 µm or more and 500 µm or less. The thickness of copper electrode 2 is not particularly limited but usually from about 5 to about 30 µm. The size and external shape of substrate 1 are also not particularly limited, and the invention can be applied to various kinds of substrates.

On the copper electrode 2 formed on substrate 1, only portions for mounting electronic components (solder joint portions) are exposed, whereas a region thereof other than the solder joint portions is covered with an insulation layer or an insulation film. Solder bump 11 is formed at the exposed solder joint portions by a means that will be described later, and solder bump 11 provided at the solder joint portions is used for solder bonding an electronic component and bonding a connection terminal (connector).

### (Mask Preparation Step)

In mask 5 to be prepared, there is formed opening portion 6 for forming solder bump 11 at necessary positions on copper electrode 2, as depicted in Fig. 1. The material of mask 5 is not particularly limited as long as the material is heat-resistant since jet stream 11' of molten solder 11a is sprayed to mask 5 and the mask 5 is in contact with molten solder 11a sprayed for a certain time. Usually, a metal mask, a heat-resistant plastic or the like is used. Opening portion 6 provided on mask 5 is opened in places necessary to provide solder bump 11 (solder joint portions) on copper electrode 2 of substrate 1.

The thickness of mask 5 is arbitrarily selected according to the thickness of solder bump 11 to be formed. Accordingly, a peripheral thickness of opening portion 6 of mask 5 restricts a height (thickness) of solder bump 11. The peripheral thickness of mask 5 is arbitrarily selected in a range of from 20 to 500 µm. In the present invention, the use of mask 5 having a thickness within such a range allows for the formation of solder bumps 11 having the same or substantially the same thickness as the peripheral thickness in a uniform thickness without variations.

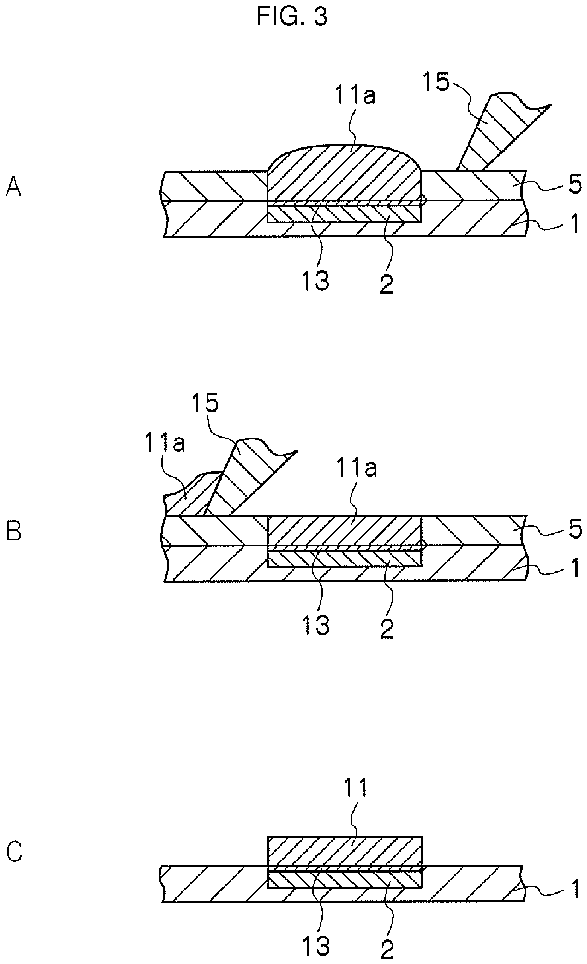

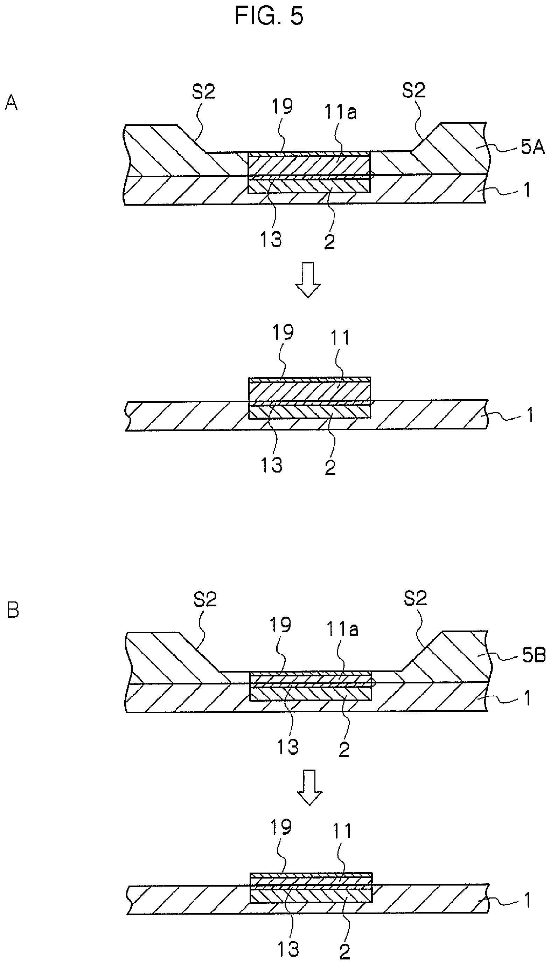

Regarding a thickness of mask 4, usually, as depicted in Figs. 3(B) and 3(C), mask 5 having the same or substantially the same thickness as the height of solder bump 11 to be formed is used to form solder bumps 11 having a predetermined thickness without dimensional variations. On the other hand, as depicted in Fig. 5(A), mask 5A may be used in which the peripheral thickness of opening portion 6 is made thin but the region other than the periphery thereof is made thick. Such a mask 5A is advantageous in that the mask as a whole is rigid and moreover solder bumps 11 having the same thickness as the small thickness of the periphery of opening portion 6 can be formed without dimensional variations. Additionally, as depicted in Fig. 5(B), mask 5B may be used in which the peripheral thickness of opening portion 6 is made thinner. Such a mask 5B is advantageous in that the mask as a whole is rigid and moreover solder bumps 11 having the same thickness as the thinner thickness of the periphery of opening portion 6 can be formed without dimensional variations.

Preferably, a boundary between the thin portion and the thick portion of each of masks 5A and 5B is gently inclined surface S2, as depicted in Figs. 5. Allowing masks 5A and 5B to have such an inclined surface S2 facilitates the removal of molten solder 11a in an excess solder removal step, which will be described later. The gently inclined surface S2 may be such a linear inclined surface or bent curved inclined surface as would not hinder the removal of molten solder 11a.

### (Solder Deposition Step)

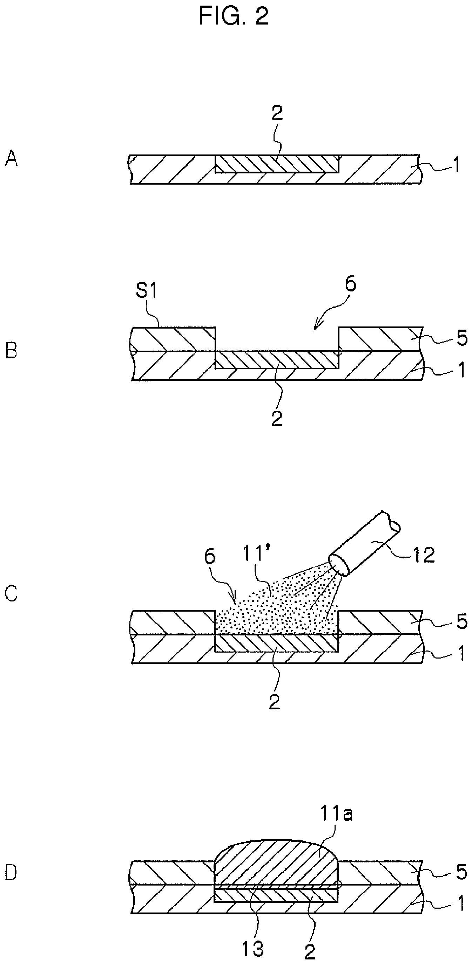

The solder deposition step is a step in which after superimposing substrate 1 and mask 5 as depicted in Figs. 1 and 2(B), jet stream 11' of molten solder is sprayed from the surface S1 side of mask 5 as depicted in Fig. 2(C) to deposit molten solder 11a on opening portion 6 of mask 5 up to a thickness thicker than the thickness of mask 5, as depicted in Fig. 2(D). Positioning for superimposing substrate 1 and mask 5 is performed using positioning marks, positioning projections, or the like provided on the substrate and the mask, respectively, and both of which are positioned with high precision.

Molten solder 11a to be used is prepared by thermally melting solder and then fluidizing to an extent allowing the solder to be sprayed as jet stream 11'. Heating temperature for solder is arbitrarily selected according to a solder composition. The temperature is determined in a range of from 150 to 300°C. The present invention uses a molten lead-free solder including tin as a main ingredient, at least nickel as an accessory ingredient, and furthermore, arbitrarily, one or two or more selected from silver, copper, zinc, bismuth, antimony, and germanium, as one or more accessory ingredients.

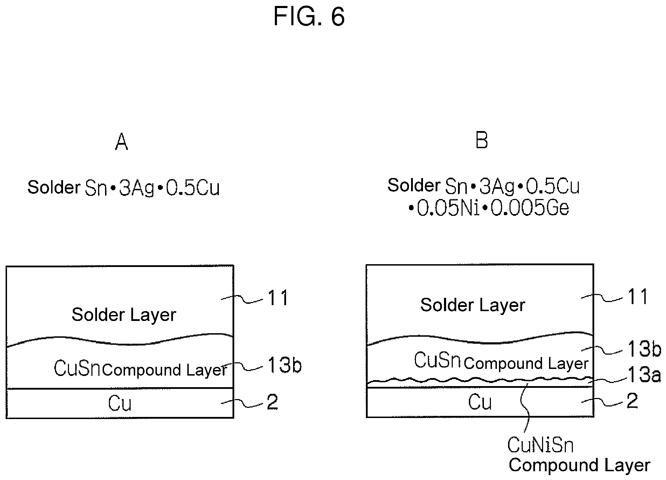

A preferable solder composition is a Sn-Ni-Ag-Cu-Ge alloy. Specifically, it is preferable to use a solder alloy including from 0.01 to 0.5% by mass of nickel, from 2 to 4% by mass of silver, from 0.1 to 1% by mass of copper, from 0.001 to 0.02% by mass of germanium, and tin for the rest in order to form Cu-Ni-Sn intermetallic compound 13a (see Fig. 6(B)) that can prevent copper corrosion stably. A particularly preferable composition for forming such a Cu-Ni-Sn intermetallic compound 13a is a solder alloy including from 0.01 to 0.07% by mass, from 0.1 to 4% by mass of silver, from 0.1 to 1% by mass of copper, from 0.001 to 0.01% by mass of germanium, and tin for the rest. In soldering with such an Sn-Ni-Ag-Cu-Ge alloy, it is preferable to use the alloy as molten solder 11a heated to a temperature of from 240 to 260°C.

In addition, when the solder includes bismuth, the heating temperature for molten solder 11a can be further lowered, and adjustment of an ingredient composition thereof can lower the heating temperature, for example, to near 150°C. A solder composition including bismuth also, as in the above, includes preferably from 0.01 to 0.5% by mass of nickel, and more preferably from 0.01 to 0.07% by mass of nickel. This composition can provide a low-temperature type molten solder 11a that can easily form Cu-Sn intermetallic compound layer 13a.

Besides, zinc and/or antimony may be added as needed. In any case, the solder composition includes at least nickel in an amount ranging preferably from 0.01 to 0.5% by mass, and more preferably from 0.01 to 0.07% by mass.

Molten solder 11a having the above composition is a lead-free solder that does not include lead and essentially includes nickel in the amount mentioned above. Thus, as depicted in Fig. 6(B), the nickel included in molten solder 11a combines with the copper of copper electrode 2 and additionally combines with the tin of molten solder 11a, whereby Cu-Ni-Sn intermetallic compound layer 13a can be easily formed on a surface of copper electrode 2. The formed Cu-Ni-Sn intermetallic compound layer 13a serves as a copper corrosion preventing layer for copper electrode 2 to prevent defects and disappearance of copper electrode 2. Accordingly, thereafter, solder bump 11 having Cu-Ni-Sn intermetallic compound layer 13a can be easily resistant even to processing that seems to be tough for copper electrode 2, as in a case of being subjected to a dipping step of dipping a substrate with the solder bump 11 formed thereon in a solder tank. Therefore, even with the use of a low-cost solder dipping step, of solder bump 11 with high yield and high reliability can be obtained. Furthermore, there can be obtained a mounting substrate with high yield, which allows for mounting of an electronic component using the solder bump 11 at low cost with high reliability.

The amount of nickel included in molten solder 11a affects a thickness of the Cu-Ni-Sn intermetallic compound layer 13a, as depicted in Examples described later. Specifically, when the nickel content is in a range of from 0.01 to 0.5% by mass (preferably to 0.07% by mass), there can be formed Cu-Ni-Sn intermetallic compound layer 13a having a substantially uniform thickness of around from 1 to 3 µm. Cu-Ni-Sn intermetallic compound layer 13a having a thickness in the above range can prevent the copper in copper electrode 2 from being dissolved into molten solder 11a or solder bump 11 to be corroded.

When the nickel content is 0.01% by mass, the thickness of Cu-Ni-Sn intermetallic compound layer 13a is from around about 1 to about 1.5 µm; when the nickel content is, for example, 0.07% by mass, the thickness of Cu-Ni-Sn intermetallic compound layer 13a is about 2 µm; and when the nickel content is 0.5% by mass, the thickness of Cu-Ni-Sn intermetallic compound layer 13a is around about 3µm.

When the nickel content is less than 0.01% by mass, the thickness of Cu-Ni-Sn intermetallic compound layer 13a is less than 1 µm, which leads to the occurrence of a region of copper electrode 2 that cannot be covered with Cu-Ni-Sn intermetallic compound layer 13a. Then, copper corrosion can easily begin from the region. When the nickel content exceeds 0.5% by mass, the thickness of hard Cu-Ni-Sn intermetallic compound layer 13a exceeds the thickness of 3 µm to be thicker and a crack occurs in the thicker Cu-Ni-Sn intermetallic compound layer 13a. As a result, copper corrosion tends to begin from the cracked portion. The nickel content is preferably from 0.01 to 0.07% by mass. In molten solder 11a having a nickel content in the above range does not cause a crack in Cu-Ni-Sn intermetallic compound layer 13a and can form a smooth uniform layer, as compared to those having a nickel content more than 0.07% by mass and not more than 0.5% by mass.

Solder used as molten solder 11a is purified solder. Specifically, a solution including from 5 to 25% by mass of an organic fatty acid having from 12 to 20 carbon atoms is heated to a temperature of from 180 to 350°C; then, the heated solution is contacted with molten solder 11a to be mixed by intensely stirring. In this way, molten solder 11a before purification, which has been contaminated with a copper oxide, a flux component, and the like, can be purified, whereby there can be obtained molten solder 11a from which the copper oxide, the flux component, and the like have been removed. Then, the mixed solution including the molten solder 11a but not including any copper oxide, any flux component, and the like is introduced in an organic fatty acid-containing solution tank. In the organic fatty acid-containing solution tank, the molten solder 11a after purification, which has been separated by a specific gravity difference, is returned to a lead-free solder solution tank from a bottom of the organic fatty acid-containing solution tank by a pump. Performing such purification processing can suppress time-dependent increases in copper concentration and impurity concentration in molten solder 11a used as a jet stream, as well as can prevent entry of impurities such as copper oxide, flux residue, and the like in the lead-free solder solution tank. As a result, a time-dependent composition change of the molten solder 11a in the lead-free solder solution tank can be suppressed, thereby allowing for the continuous formation of solder bump 11 using molten solder 11a stable and highly reliable in bonding. Additionally, a mounting substrate provided with such solder bumps 11 can be continuously manufactured.

Molten solder 11a purified does not include any impurities such as copper oxide and flux residue that affect bonding quality of solder bump 11. As a result, there is no interlot variation in the bonding quality between solder bump 11 and an electronic component, which can be a contribution to time-dependent quality stability.

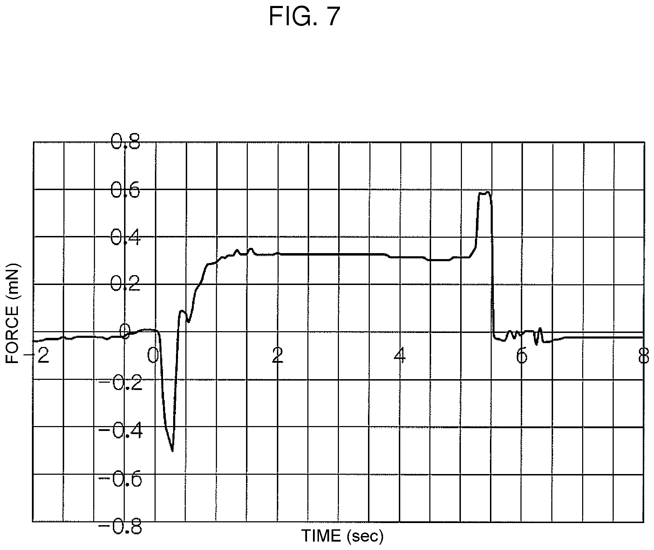

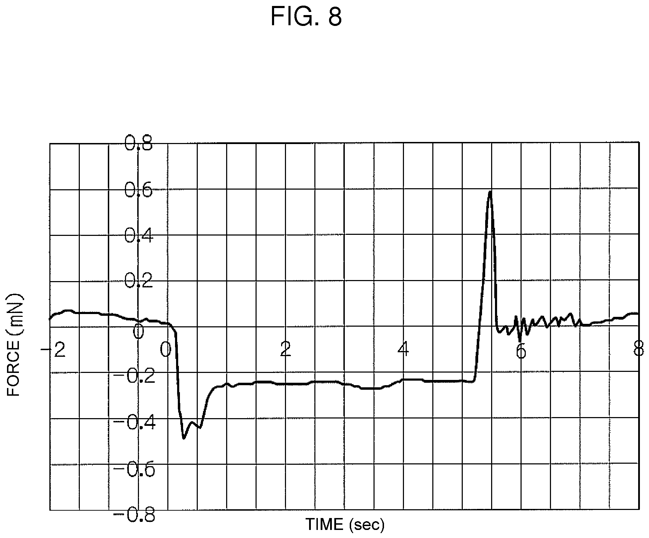

In addition, results have shown that molten solder 11a purified with the organic fatty acid-containing solution has less wettability than molten solder not purified therewith. Specifically, as seen from the results of wettability (meniscograph) tests of Figs. 7 and 8 obtained in Example and Comparative Example described later, molten solder 11a purified had a zero cross time of 0.4 seconds, whereas unpurified molten solder had a zero cross time of 5 seconds. In addition, results have shown that molten solder 11a purified with the organic fatty acid-containing solution has significantly smaller viscosity than molten solder not purified therewith. Specifically, as seen from the results obtained in Example and Comparative Example, which will be described later, purified molten solder 11a had a viscosity of from 0.003 to 0.004 Pa·s, whereas unpurified molten solder had a viscosity of from 0.005 to 0.006 Pa·s, so that there was a significant difference between both solders. The viscosities were measured by a vibrating reed viscometer.

The above characteristic differences between the purified molten solder 11a and the unpurified molten solder means that jet stream 11' of molten solder 11a uniformly spreads with favorable solder wettability throughout the surface of copper electrode 2. Particularly, before spraying molten solder 11a onto copper electrode 2, the organic fatty acid-containing solution used for purification is contacted (spraying or immersion) with the copper electrode 2 to perform cleaning so that the organic fatty acid-containing solution removes oxides, impurities, and the like present on the copper surface. Then, molten solder 11a similarly purified with the organic fatty acid-containing solution is sprayed onto the copper surface thus cleaned to allow the solder to adhere thereto, whereby molten solder 11a can wet-spread with good wettability on copper surface 2. On the other hand, when unpurified molten solder was sprayed onto a cleaned copper surface to allow the solder to adhere thereto, the solder did not wet spread with good wettability, unlike the above, and there were cases in which the molten solder did not wet-spread uniformly on the copper surface. These results show that it is significantly effective to spray molten solder 11a purified with the organic fatty acid-containing solution onto a copper surface cleaned therewith to allow the solder to adhere to the surface.

The organic fatty acid contained in the organic fatty acid-containing solution used for purification may be one having 11 or less carbon atoms. However, such an organic fatty acid is water-absorbent and not very preferable for use in the higher temperature range of from 180 to 350°C mentioned above. Additionally, organic fatty acids having 21 or more carbon atoms are problematic in terms of high melting points, poor permeability, poor handleability, and the like, and also the surface of molten solder 11a after purification has insufficient anti-rust effect. Typically, palmitic acid having 16 carbon atoms is preferable. It is particularly preferable to only use the palmitic acid having 16 carbon atoms, and, the organic fatty acid has from 12 to 20 carbon atoms, such as stearic acid having 18 carbon atoms.

The organic fatty acid-containing solution used for purification preferably includes from 5 to 25% by mass of palmitic acid and an ester synthetic oil for the rest. The use of such an organic fatty acid-containing solution heated to a temperature of from 180 to 350°C allows the solution to selectively capture impurities such as oxides and flux ingredients present in molten solder 11a to purify molten solder 11a. Particularly preferred is an organic fatty acid-containing solution that contains around 10% by mass (for example, from 5 to 15% by mass) of palmitic acid having 16 carbon atoms. The organic fatty acid-containing solution includes neither metal salts such as nickel salt and cobalt salt nor additives such as an antioxidant.

The use of organic fatty acids having concentrations of below 5% by mass reduces the effect of selectively capturing impurities such as oxides and flux ingredients present in molten solder 11a to purify, and furthermore makes control at low temperature complicated. On the other hand, when the concentration of the organic fatty acid exceeds 25% by mass, there arise problems, such as a significant increase in the viscosity of the organic fatty acid-containing solution, the occurrence of fumes and odors in a high temperature range of 300°C or more, and insufficient stirring mixability with molten solder 11a. Therefore, the content of the organic fatty acid is from 5 to 25% by mass, and particularly when using only palmitic acid having 16 carbon atoms, the content of the organic fatty acid is preferably around 10% by mass (for example, from 5 to 15% by mass).

The temperature of the organic fatty acid-containing solution used for purification is determined by a melting point of molten solder 11a to be purified, and the organic fatty acid-containing solution and molten solder 11a are contacted with each other by intensely stirring in a high temperature region (one example is from 240 to 260°C) of not less than at least a melting point of molten solder 11a. In addition, an upper limit temperature of the organic fatty acid-containing solution is around 350°C from the viewpoint of a fuming problem and energy saving, and preferably in a range of from a temperature of not less than the melting point of molten solder 11a to be purified to 300°C. For example, the solder alloy including from 0.01 to 0.07% by mass of nickel, from 0.1 to 4% by mass of silver, from 0.1 to 1% by mass of copper, from 0.001 to 0.01% by mass of germanium, and tin for the rest is used as molten solder 11a at a temperature of from 240 to 260°C. Thus, preferably, the temperature of the organic fatty acid-containing solution is also in the same temperature range of from 240 to 260°C as the solder alloy.

Reasons for mixing an ester synthetic oil in the organic fatty acid-containing solution are to facilitate uniform stirring mixing between the organic fatty acid-containing solution and molten solder 11a by lowering the viscosity of the organic fatty acid-containing solution and to suppress high-temperature fuming properties of the organic fatty acid contained in the solution.

Molten solder 11a purified with such an organic fatty acid-containing solution is sprayed as jet stream 11' to opening portion 6 of mask 5 from a spray nozzle, as depicted in Fig. 2(C). In this manner, deposited molten solder 11a is provided, as depicted in Fig. 2(D).

An atmosphere for spraying is not particularly limited. However, since excess molten solder 11a is removed after that by a squeegee, liquid shower, or gaseous shower, an atmosphere temperature during processing in both steps of "solder deposition step" and "excess solder removal step" is needed to be maintained at a temperature that can keep the molten state of molten solder 11a as it is (a temperature of from 240 to 260°C in the above example). Specifically, the atmosphere temperature is preferably a temperature equal or close to a temperature of molten solder 11a to be used for soldering. The temperature is preferably set to be slightly higher than the temperature of molten solder 11a, although can be equal thereto. For example, the atmosphere temperature is set to be preferably from 2 to 10°C higher, and more preferably from 2 to 5°C higher than a jet stream temperature of molten solder 11a. Setting the atmosphere temperature within the above temperature range allows jet stream 11' of molten solder 11a sprayed on the surface of copper electrode 2 to be flown uniformly on the surface thereof, and particularly allows molten solder 11a to spread throughout the inside of mask 5. Atmosphere temperatures lower than the temperature of the jet stream of molten solder 11a can reduce the fluidity of molten solder 11a. On the other hand, atmosphere temperatures higher than 10°C may thermally damage the substrate due to the excessively high temperatures.

### (Excess Solder Removal Step)

The excess solder removal step is a step of removing molten solder 11a protruding from a surface of mask 5 in a thickness direction thereof (which can also be referred to as exceeding the thickness of mask 5) to form solder bump 11 having a predetermined thickness, as depicted in Figs. 3(A) and 3(B). Removal of molten solder 11a exceeding the thickness of mask 5 is performed by a removing means such as blade 15 or an air cutter, or alternatively performed by a removing means that sprays organic fatty acid-containing solution 18 having from 12 to 20 carbon atoms. In this way, solder 11 protruding from the surface of mask 5 in the thickness direction thereof can be removed.

Blade 15 usable may be a plate-shaped blade generally used for scraping off, as depicted in Figs. 3(A) and 3(B). In addition, the air cutter (not shown) usable may be a nozzle that allows air or an inert gas (such as nitrogen gas or argon gas) to be sprayed vigorously from a tip of an air spray nozzle. The air cutter can blow off and remove molten solder 11a protruding from the surface of mask 5 in the thickness direction thereof.

In addition, in the present invention, preferred is a removing means that sprays organic fatty acid-containing solution 18 having from 18 to 20 carbon atoms from nozzle 17 to blow off molten solder 11a protruding from the surface of mask 5 in the thickness direction thereof. Furthermore, such a means that removes molten solder 11a by spraying can form coating film 19 of organic fatty acid contained in organic fatty acid-containing solution 18 on solder bump 11.

A flow rate of jet stream 11' of molten solder sprayed from nozzle 17 and a time for spraying processing are arbitrarily determined in consideration of the kind of molten solder 11a, a thickness of coating film 19, and the like. Additionally, conditions such as a shape of nozzle 17 and a spraying angle thereof are also arbitrarily applied or determined in consideration of the kind of molten solder 11a, the thickness of coating film 19, and the like. Although the spraying angle is not particularly limited, a virtual angle between a center axis of nozzle 17 and the mask surface is set to be preferably within a range of from 30 to 45 degrees. Depending on the flow rate of jet stream 11' of molten solder and the time for spraying processing, molten solder 11a under the surface of mask 5 may also be removed along with the removal of molten solder 11a protruding from the surface of mask 5 in the thickness direction thereof. As a result, the surface of molten solder 11a after the spraying may be slightly concaved. A configuration after the removal of the excess also molten solder 11a includes a configuration after such a removal.

Organic fatty acid-containing solution 18 to be sprayed may include some amount of an inert gas such as nitrogen gas. On the other hand, oxygen-containing air, water, and the like are not allowed to be included from the viewpoint of oxidation of molten solder 11a and compatibility with the organic fatty acid-containing solution.

The atmosphere temperature during processing in the removal step is maintained at a temperature that can keep the molten state of molten solder 11a, as it is, deposited the opening portion 6. Such a temperature varies depending on the kind of molten solder 11a to be used. In the above example, the temperature needs to be maintained at a temperature of from 240 to 260°C.

In the removal of an excess of molten solder 11a by spraying organic fatty acid-containing solution 18 using a spray, the organic fatty acid-containing solution 18 to be used is preferably the same organic fatty acid-containing solution as that used in the purification processing described above. In other words, it is preferable to use an organic fatty acid-containing solution containing form 5 to 25% by mass of organic fatty acid having from 12 to 20 carbon atoms. Particularly preferred is an organic fatty acid-solution containing from 5 to 15% by mass of palmitic acid having 16 carbon atoms. As needed, an organic fatty acid having from 12 to 20 carbon atoms, such as stearic acid having 18 carbon atoms may be contained. The organic fatty acid-containing solution includes neither metal salts such as nickel salt and cobalt salt nor additives such as an antioxidant.

The organic fatty acid-containing solution is preferably heated in the same temperature range as the temperature of molten solder 11a, and for example, an organic fatty acid-containing solution heated to from 180 to 350°C is used. When molten solder 11a is heated to from 240 to 260°C and sprayed as jet stream 11' as in the above, it is preferable to spray an organic fatty acid-containing solution having the same temperature of from 240 to 260°C as the temperature of the sprayed molten solder 11a to remove an excess of molten solder 11a. The organic fatty acid-containing solution sprayed by a spray and the molten solder 11a removed together with the sprayed organic fatty acid-containing solution are separated by a specific gravity difference, and molten solder 11a that has sunk at a bottom of the organic fatty acid-containing solution is taken out and can be separated from the organic fatty acid-containing solution. The molten solder 11a and the organic fatty acid-containing solution separated from each other can be reused.

As described above, the organic fatty acid contained in the organic fatty acid-containing solution may be one having 11 or less carbon atoms. However, such an organic fatty acid is water-absorbent and thus not very preferable for use in the high temperature range of from 180 to 350°C mentioned above. In addition, organic fatty acids having 21 or more carbon atoms are problematic in terms of high melting points, poor permeability, poor handleability, and the like, and also the anti-rust effect of coating film 19 formed on the surface of molten solder 11a is insufficient. Typically, palmitic acid having 16 carbon atoms is preferable, and the use of the above palmitic acid alone is particularly preferable. When needed, it is possible to contain an organic fatty acid having from 12 to 20 carbon atoms, such as stearic acid having 18 carbon atoms.

Preferably, the temperature of the organic fatty acid-containing solution is the same or substantially the same as the temperature of molten solder 11a to be removed, thereby allowing molten solder 11a to be blown off without being cooled down.

After removing the excess of molten solder 11a by spraying the organic fatty acid-containing solution to molten solder 11a, coating film 19 of the organic fatty acid forming the organic fatty acid-containing solution is formed on the surface of molten solder 11a. The formed coating film 19 cleans the surface of molten solder 11a and additionally suppresses oxidation of molten solder 11a so that the formation of an oxide film can be prevented.

### (Mask Removal Step)

Finally, mask 5 is removed, as depicted in Fig. 3(C). Removal of mask 5 allows for the formation of solder bump 11 having a predetermined thickness. Cool-down from molten solder 11 to solder bump 11 can be performed either before or after removing mask 5. The cool-down may be performed by allowing to cool or forced cooling. Forced cooling can be done by spraying air or an inert gas (such as nitrogen gas or argon gas) for cool-down.

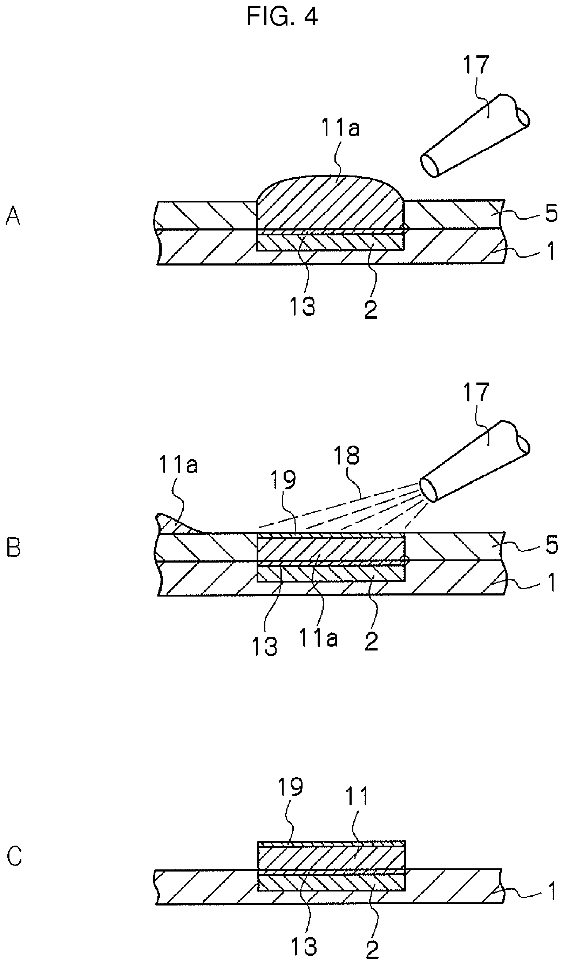

The thickness of solder bump 11 is the same or substantially the same as the thickness of mask 5, and thicknesses of nearly all of a plurality of solder bumps 11 formed were the same. When molten solder 11a has been removed by a removing means using a member such as blade 15 or an air cutter, coating film 19 of the organic fatty acid as depicted in Figs. 4(B) and 4(C) described above is not provided on the surface of solder bump 11. On the other hand, when an excess solder has been removed by spraying the organic fatty acid-containing solution, coating film 19 of the organic fatty acid as depicted in Figs. 4(B) and 4(C) described above is provided on the surface of solder bump 11.

Particularly, palmitic acid is preferable since the acid contacts with molten solder 11a or solder bump 11 and cleans the surface of molten solder 11a or solder bump 11 more effectively. Furthermore, coating film 19 with the palmitic acid adsorbed thereto is formed on the surface of molten solder 11a or solder bump 11. Accordingly, even after that, the coating film 19 can maintain the surface of molten solder 11a or solder bump 11 in such a clean state as to suppress the occurrence of an oxide. As a result, even when the substrate passes through a plurality of heating furnaces during mounting of electronic components thereon, it can be suppressed that the heat oxidizes the surface of solder bump 11 to bring the surface into a state that hinders soldering. Then, the electronic components can be soldered to solder bumps 11 without soldering failure.

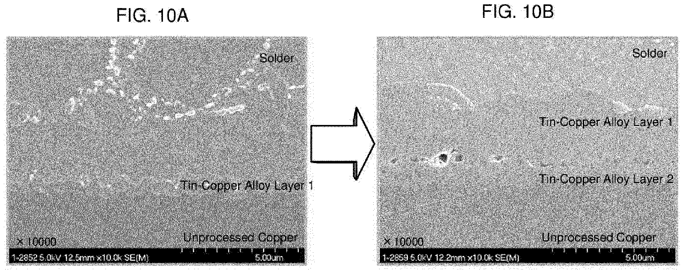

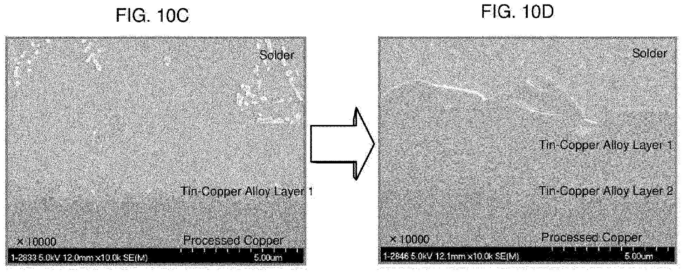

Moreover, solder bump 11 formed by the method for forming solder bump 11 according to the present invention can minimize the occurrence of micro voids, as depicted in Fig. 10. Therefore, solder joint portions can have significantly high reliability even when a plurality of heat histories are added after mounting of electronic components or even when the mounting substrate is incorporated in an electronic apparatus and used by a consumer for a long period of time. Solder bump 11 forming such highly reliable solder joint portions can be obtained only by the method according to the present invention.

As described hereinabove, the solder bump forming method according to the present invention sprays jet stream 11' of molten solder including tin as the main ingredient and at least nickel as the accessory ingredient to opening portion 6. Accordingly, Cu-Ni-Sn intermetallic compound layer 13a produced by alloying of the copper of copper electrode 2 and the nickel of molten solder 11a is formed on the surface of copper electrode 2. The Cu-Ni-Sn intermetallic compound layer 13a formed on the surface of copper electrode 2 serves as a barrier layer against copper corrosion. The barrier layer prevents copper corrosion of copper electrode 2, so that defects or disappearance of copper electrode 2 due to copper corrosion can be prevented. As a result, reliability can be ensured for copper electrode 2 such as a copper land of a mounting substrate, and when soldering an electronic component on a mounting substrate, copper corrosion occurring in conventional soldering can be suppressed.

In addition, in the method for forming solder bump 11 according to the invention, the removal of molten solder 11a exceeding the thickness of mask 5 is performed by a simple means, that is, a removing means such as blade 15 or an air cutter or a removing means that sprays organic fatty acid-containing solution 18 having from 12 to 20 carbon atoms. Thus, solder bumps 11 having a desired constant thickness can be formed easily with high dimensional precision on a mounting substrate with minute copper electrode 2 thereon. Consequently, such a high-cost step as in the conventional art is unnecessary, thus allowing for increase in reliability and yield of joint portions where electronic components are solder-bonded to solder bumps 11. This is advantageous in terms of manufacturing a low-cost mounting substrate.

Particularly, recent years have seen improvement in the wiring density of copper electrode 2 and the mounting density of electronic components. Accordingly, in order to achieve high-yield solder-bonding of electronic components onto substrate 1, solder bump 11 is becoming more minute and it is moreover expected that there is no thickness variation. The present invention is a method for forming solder bump 11 that can meet the expectation. The invention can form solder bumps 11 having a constant thickness on substrate 1 even when there are dimensional variations between connection terminals such as a connector, a QFP (Quad Flat Package), a SOP (Small Outline Package), a BGA (Ball Grid Array), and the like, so that there is an advantage that can achieve stable and highly reliable solder bonding. As a result, even when electronic components having such variations or large and small electronic components are mounted on a substrate, stable solder bonding can be achieved.

### [Mounting Substrate Manufacturing Method]

A method for manufacturing a mounting substrate according to the present invention is characterized in that solder bump 11 is formed at a joint portion of copper electrode 2 for mounting an electronic component by the above-described solder bump forming method according to the invention and the electronic component is soldered and mounted to the formed solder bump 11. This can ensure the reliability of copper electrode 2 such as a copper land of a mounting substrate and can suppress copper corrosion occurring in conventional soldering when an electronic component is soldered to a mounting substrate. In addition, solder bump 11 having a desired constant thickness can be formed easily with high dimensional precision on the mounting substrate provided with minute copper electrode 2. In the present invention described above, such a high-cost step as in the conventional art is unnecessary, thus allowing for increase in reliability and yield of joint portions where electronic components are solder-bonded to the solder bumps, so that a low-cost mounting substrate can be manufactured.

Examples of the substrate include various kinds of substrates such as a printed circuit board, a wafer, and a flexible substrate. Particularly, it is preferable for a wafer to apply the method according to the present invention, since the width and pitch of copper electrodes on the wafer are narrow, and solder bump 11 can be provided with high precision on the narrow-pitch micro electrodes. In addition, even on a printed circuit board or a flexible substrate where large electronic components are to be provided, solder bump 11 can be formed with a uniform thickness, and moreover the surface of solder bump 11 can be kept in a cleaned state. Accordingly, the invention can have a significantly great advantageous effect in that even electronic components having dimensional variations can be mounted without any soldering failure and without any a concern about the occurrence of micro voids as depicted in Figs. 10.

Examples of the electronic components include a semiconductor chip, a semiconductor module, an IC chip, an IC module, a dielectric chip, a dielectric module, a resistor chip, and a resistor module.

### Examples

The present invention will be described in more detail below with reference to Examples and Comparative Examples.

### [Example 1]

As one example, there was prepared substrate 1 having a copper wiring pattern having a width of, for example, 200 µm and a thickness of, for example, 10 µm formed thereon. On the substrate 1, there were exposed only joint portions of the copper wiring pattern that were to be portions for mounting electronic components and had a width of, for example, 200 µm and a length of, for example, 50 µm, whereas the other portions of copper electrode 2 were covered with an insulation layer. There was prepared mask 5 provided with opening portions 6 used for forming solder bumps 11 at such joint portions. Positions of the joint portions where copper electrode 2 was exposed on substrate 1 were matched with positions of the opening portions 6 of mask 5 to superimpose with each other. Then, using a quinary lead-free solder consisting of Ni: 0.05% by mass, Ge: 0.005% by mass, Ag: 3% by mass, Cu: 0.5% by mass, and Sn for the rest, the solder was heated to 250°C to obtain molten solder 11a, and jet stream 11' of the molten solder was jetted to opening portions 6. Jet stream 11' of the molten solder was sprayed using a jetting apparatus in a state where nozzle 12 was inclined, for example, by 45 degrees at an atmosphere temperature of around 250°C so that the temperature of molten solder 11a heated to 250°C was not lowered. In the configuration of opening portions 6 after the jetting of jet stream 11' of the molten solder, molten solder 11a was in a swollen state due to surface tension. The molten solder 11a was allowed to keep the molten state by a vapor atmosphere temperature.

Next, palmitic acid was added up to 10% by mass in an ester synthetic oil including neither metal salts such as nickel salt and cobalt salt nor additives such as an antioxidant to prepare an organic fatty acid-containing solution. The organic fatty acid-containing solution was heated to 250°C to obtain heated organic fatty acid-containing solution 18, which was then jetted to opening portions 6 with the molten solder 11a swollen therein. Molten solder 11a at this time kept the molten state. The jetting of organic fatty acid-containing solution 18 was performed in a state where nozzle 17 was inclined, for example, by 30 degrees using a spraying apparatus heated so that the temperature of the organic fatty acid-containing solution heated to 250°C was not lowered. In opening portions 6 after the jetting of organic fatty acid-containing solution 18, it was found that molten solder 11a was provided at the same height as that of a surface of mask 5.

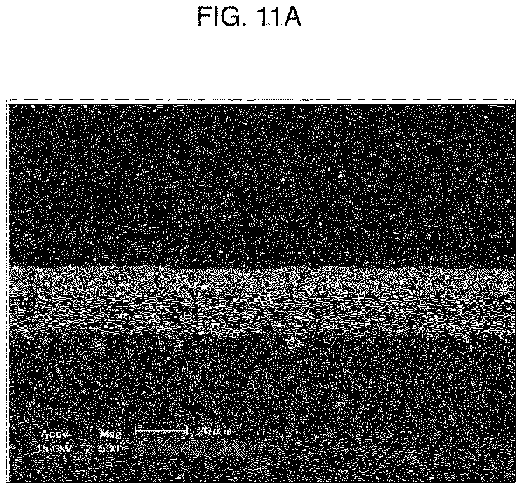

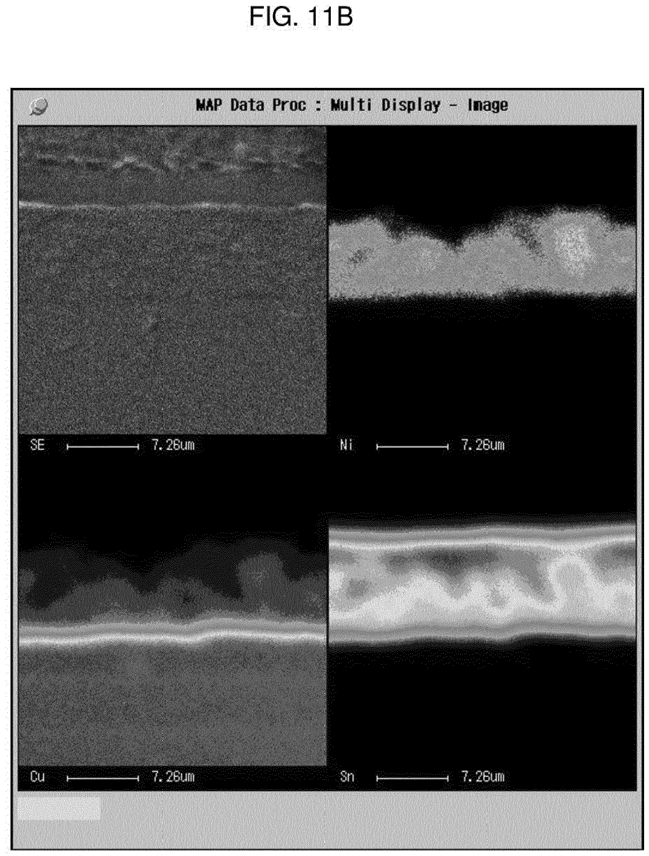

After that, molten solder 11a was allowed to cool to obtain solder bumps 11, and then mask 5 was removed to form solder bumps 11 according to Example 1 of the present invention. Scanning electron micrographic views of a section of obtained solder bump 11 were shown in Figs. 10, and an element mapping of the section was shown in Figs. 11. The sectional micrographs shown in Figs. 10 indicated that Cu-Ni-Sn intermetallic compound layer 13a was formed uniformly with a thickness of 1.5 µm.

### [Example 2]

Solder bumps 11 according to Example 2 were formed in the same manner as in Example 1 except for using a quinary lead-free solder consisting of, as solder materials, Ni: 0.03% by mass, Ge: 0.005% by mass, Ag: 3% by mass, Cu: 0.5% by mass, and Sn for the rest. Similarly to Example 1, scanning electron micrographs of a section of obtained solder bump 11 were taken and indicated that Cu-Ni-Sn intermetallic compound layer 13a was formed with a thickness of 1 µm, although unevenness was slightly observed.

### [Example 3]

Solder bumps 11 according to Example 3 were formed in the same manner as in Example 1 except for using a quinary lead-free solder consisting of, as solder materials, Ni: 0.07% by mass, Ge: 0.005% by mass, Ag: 3% by mass, Cu: 0.5% by mass, and Sn for the rest. Similarly to Example 1, scanning electron micrographs of a section of obtained solder bump 11 were taken and indicated that Cu-Ni-Sn intermetallic compound layer 13a was formed uniformly with a thickness of 2 µm.

### [Example 4]

Solder bumps 11 according to Example 4 were formed in the same manner as in Example 1 except for changing the content of palmitic acid in the organic fatty acid-containing solution to 7% by mass. Similarly to Example 1, scanning electron micrographs of a section of obtained solder bump 11 were taken and indicated that Cu-Ni-Sn intermetallic compound layer 13a was formed uniformly with a thickness of 1.5 µm.

### [Example 5]

Solder bumps 11 according to Example 5 were formed in the same manner as in Example 1 except for changing the content of palmitic acid in the organic fatty acid-containing solution to 12% by mass. Similarly to Example 1, scanning electron micrographs of a section of obtained solder bump 11 were taken and indicated that Cu-Ni-Sn intermetallic compound layer 13a was formed uniformly with a thickness of 1.5 µm.

### [Comparative Example 1]

Solder bumps 11 according to Comparative Example 1 were formed in the same manner as in Example 1 except for using a ternary lead-free solder consisting of, as solder materials, Ag: 3% by mass, Cu: 0.5% by mass, and Sn for the rest. Similarly to Example 1, scanning electron micrographs of a section of obtained solder bump 11 were taken and indicated that no Cu-Ni-Sn intermetallic compound layer was present (see Fig. 6(A)) and Cu-Sn intermetallic compound layer 13b was formed on copper electrode 2.

### [Comparative Example 2]

Solder bumps 11 according to Comparative Example 2 were formed in the same manner as in Example 1 except for using a quinary lead-free solder consisting of, as solder materials, Ni: 0.005% by mass, Ge: 0.005% by mass, Ag: 3% by mass, Cu: 0.5% by mass, and Sn for the rest. Similarly to Example 1, scanning electron micrographs of a section of obtained solder bump 11 were taken and indicated that Cu-Ni-Sn intermetallic compound layer 13a was extremely uneven and not continuous as a film.

### [Comparative Example 3]

Solder bumps 11 according to Comparative Example 3 were formed in the same manner as in Example 1 except for using a quinary lead-free solder consisting of, as solder materials, Ni: 1% by mass, Ge: 0.005% by mass, Ag: 3% by mass, Cu: 0.5% by mass, and Sn for the rest. Similarly to Example 1, scanning electron micrographs of a section of obtained solder bump 11 were taken and indicated that Cu-Ni-Sn intermetallic compound layer 13a was formed with a thickness of 5 µm and cracking was observed.

### [Comparative Example 4]

Solder bumps 11 according to Comparative Example 4 were formed in the same manner as in Example 1 except for changing the content of palmitic acid in the organic fatty acid-containing solution to 1% by mass. Similarly to Example 1, scanning electron micrographs of a section of obtained solder bump 11 were taken and indicated that Cu-Ni-Sn intermetallic compound layer 13a was formed uniformly with a thickness of 1.5 µm. but the surface of the layer had discoloration that seemed to be due to oxidation.

### [Comparative Example 5]

Solder bumps 11 according to Comparative Example 5 were formed in the same manner as in Example 1 except for changing the content of palmitic acid in the organic fatty acid-containing solution to 30% by mass. Similarly to Example 1, scanning electron micrographs of a section of obtained solder bump 11 were taken and indicated that Cu-Ni-Sn intermetallic compound layer 13a was formed uniformly with a thickness of 1.5 µm.

### [Measurement and Results]

### (Evaluation on Occurrence of Void)

The thickness of Cu-Ni-Sn intermetallic compound layer 13a was measured from the sectional scanning electron micrograph of solder bump 11. In addition, the presence or absence of a void near a bonding interface between copper electrode 2 and solder bump 11 was evaluated from the sectional scanning electron micrograph thereof taken after aging at 150°C for 240 hours. Figs. 10(A) and 10(B) depict results of Comparative Example 1, and Figs. 10(C) and 10(D) depict results of Example 1. As depicted in Figs. 10, solder bump 11 of Comparative Example 1 had voids at the interface with copper electrode 2, whereas solder bump 11 of Example 1 had no void at the interface with copper electrode 2.

### (Element Mapping)

Figs. 11 depict a scanning electron micrograph of a section near the bonding interface between solder bump 11 and copper electrode 2 in Example 1 and an element mapping by an X-ray micro analyzer (EPMA). As depicted in Figs. 11, a nickel element can be observed to be distributed on copper electrode 2 and Cu-Ni-Sn intermetallic compound layer 13a is found to be formed.

### (Wettability and Oxygen Content)

Fig. 7 is the wettability (meniscograph) test result of a molten solder purified with the organic fatty acid-containing solution, and Fig. 8 is the wettability (meniscograph) test result of an unpurified molten solder. As seen from the results of the solder wettability (meniscograph) tests of Figs. 7 and 8, the purified molten solder 11a depicted in Fig. 7 had a zero cross time of 0.4 seconds, whereas the unpurified molten solder 11a depicted in Fig. 8 had a zero cross time of 5 seconds. This showed that the molten solder 11a purified with the organic fatty acid-containing solution had less wettability than the molten solder unpurified with the organic fatty acid-containing solution.

Viscosity was measured on molten solder 11a purified with the organic fatty acid-containing solution and molten solder 11a unpurified with the organic fatty acid-containing solution by a vibrating reed viscometer. Molten solder 11a purified with the organic fatty acid-containing solution had a viscosity of from 0.003 to 0.004 Pa.s, more particularly 0.0038 Pa·s at 220°C, 0.0036 Pa·s at 240°C, 0.0035 Pa·s at 260°C, and 0.0034 Pa·s at 280°C. On the other hand, molten solder 11a unpurified therewith had a viscosity of from 0.005 to 0.006 Pa·s, more particularly 0.0060 Pa·s at 220°C, 0.0058 Pa·s at 240°C, 0.0056 Pa·s at 260°C, and 0.0054 Pa·s at 280°C. Thus, both solders had a significant difference.

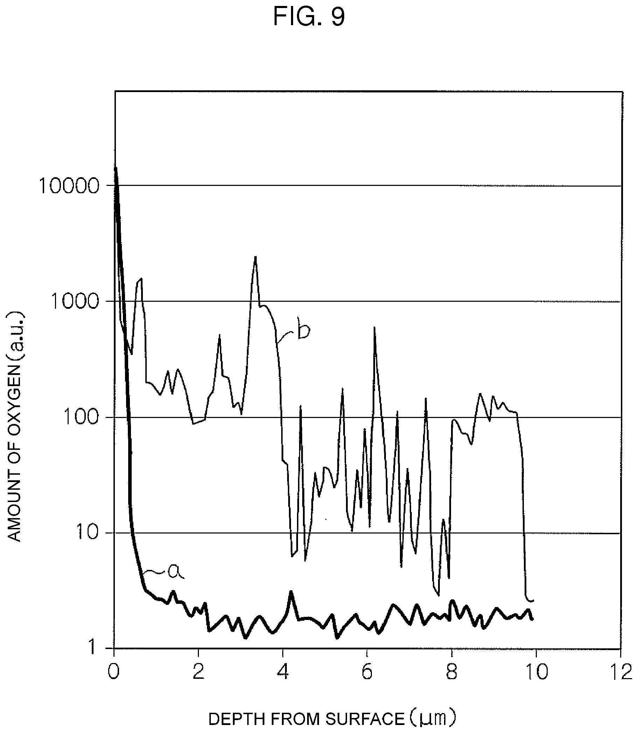

In addition, Fig. 9 is a graph depicting the amounts of oxygen in depth directions of solder layers. The amounts of oxygen in the solder layers are results measured by a time-of-flight secondary ion mass spectrometer (TOF-SIMS). As seen from Fig. 9, an oxygen amount "a" of a solder layer formed using the purified molten solder was remarkably smaller than an oxygen amount "b" of a solder layer formed using the unpurified molten solder. The oxygen amounts at that time were quantified. In the quantification, the amounts of oxygen between positions of from 1 to 10 µm from a surface of each solder layer were quantified in a thickness direction of the layer, and evaluation was made based on average values. As a result, the amount of oxygen of the solder layer obtained using the purified molten solder was 10 ppm or less, specifically from 3 to 4 ppm, whereas the amount of oxygen of the solder layer obtained using the unpurified molten solder was about 200 ppm.

The characteristic differences between the purified molten solder and the unpurified molten solder as described above indicate the reason that jet stream 11' of molten solder spreads uniformly with favorable solder wettability throughout the surface of copper electrode 2. In other words, the purified molten solder wet-spread favorably on copper surface 2 due to the small viscosity and good wettability thereof, whereas the unpurified molten solder did not wet-spread uniformly on the copper surface. The same results were also shown on copper surfaces cleaned with the organic fatty acid-containing solution.

The amounts of oxygen in the solder layers depicted in Fig. 9 seem to be closely related with the occurrence of the voids depicted in Figs. 10 and with the wettabilities in Figs. 7 and 8. In other words, the difference between the amounts of oxygen in the solder layers can be regarded as a difference between the amount of oxygen in the purified molten solder and the amount of oxygen in the unpurified molten solder. Therefore, it seems that influence of such amounts of oxygen makes the difference in the occurrence of voids and also makes the differences in solder wettability and viscosity.

### Descriptions of Reference Numerals

- 1: Substrate
- 2: Copper electrode
- 5, 5A, 5B: Mask
- 6: Opening protion
- 11: Solder bump
- 11a: Molten solder
- 11': Jet stream of molten solder
- 12: Jet stream nozzle
- 13a: Cu-Ni-Sn intermetallic compound layer
- 13b: Cu-Sn intermetallic compound layer
- 15: Blade
- 17: Spray nozzle
- 18: Organic fatty acid-containing solution
- 19: Coating film
- S 1: Surface
- S2: Inclined surface

## Claims

1. A forming method of solder bumps (11), comprising:
preparing a substrate (1) that has a copper electrode (2); whereby on the copper electrode (2) only portions for mounting electronic components are exposed, whereas other portions of the substrate are covered with an insulation layer or an insulation film;
preparing a mask (5) from a layer of heat-resistant material, the layer being provided with an opening portion (6), the mask having a thickness in the range of from 20 to 500 µm; and
subsequently overlapping the mask (5) and the substrate (1) by matching and superimposing the position of the opening portion in the mask with the position of the copper electrode;
piling up a molten solder (11a) by spraying a jet stream of the molten solder at a temperature of not less than 150 °C and not more than 300 °C, wherein the substrate is held in a horizontal position during spraying and the jet stream of the molten solder is sprayed from above until a thickness of the molten solder (11a) is greater than a thickness of the mask (6), wherein the molten solder is purified by a refining process;
forming the solder bumps (11) having the predetermined thickness by removing an excess of the molten solder (11a) that is piled up beyond the thickness of the mask (6); and removing the mask (6) from the overlapped substrate (1), wherein an atmosphere temperature during processing in both the step of piling up the molten solder (11a) and the step of forming the solder bumps (11) by removing the excess of the molten solder (11a) is maintained at a temperature that can keep the molten state of molten solder (11a) as it is;
the refining process is performed by stirring and mixing the molten solder (11a) with a solution including 5 % to 25 % by mass of organic fatty acid and having 12 to 20 carbon atoms and being heated to a temperature of from 180 °C to 350 °C;
the molten solder (11a) is molten lead-free solder that includes tin as a main component and at least nickel as an accessory component, and further includes one or more components selected from among silver, copper, zinc, bismuth, antimony and germanium as an optional accessory component, and removing the excess of the molten solder (11a) piled up beyond the thickness of the mask (6) is performed by a removal unit, selected from a group consisting of a blade, an air cutter, and a removal unit spraying organic fatty acid-containing solution having 12 to 20 carbon atoms.

2. The forming method of solder bumps (11) according to claim 1, wherein a coating film having organic fatty acid in the organic fatty acid-containing solution is formed on the solder bumps (11).

3. The forming method of solder bumps according to claim 1 or 2, wherein the organic fatty acid-containing solution is solution including palmitic acid having 16 atoms.

4. A method for manufacturing a mounting substrate, comprising:
forming solder bumps (11) on a surface of a copper electrode (2) by the forming method of solder bumps (11) according to any one of claims 1 to 3; and mounting an electronic component by soldering on the formed solder bumps (11).

## Patentansprüche

1. Verfahren zur Bildung von Löthöckern (11) umfassend:
Vorbereiten eines Substrats (1), das eine Kupferelektrode (2) aufweist; wodurch auf der Kupferelektrode (2) nur Bereiche zum Anbringen elektronischer Komponenten freiliegend sind, wohingegen andere Bereiche des Substrats mit einer Isolationsschicht oder einem Isolationsfilm bedeckt sind;
Vorbereiten einer Maske (5) aus einer Schicht eines wärmeresistenten Materials, wobei die Schicht mit einem Öffnungsbereich (6) bereitgestellt wird, wobei die Maske eine Dicke im Bereich von 20 bis 500 µm aufweist; und
anschließendes Überlappen der Maske (5) und des Substrats (1) durch Anpassen und Überlagern der Position des Öffnungsbereiches in der Maske mit der Position der Kupferelektrode;
Aufstapeln eines geschmolzenen Lots (11a) durch Sprühen eines Düsenstrahls des geschmolzenen Lots bei einer Temperatur von nicht weniger als 150 °C und nicht mehr als 300 °C, wobei das Substrat während des Sprühens in einer horizontalen Position gehalten wird und der Düsenstrahl des geschmolzenen Lots von oben gesprüht wird, bis eine Dicke des geschmolzenen Lots (11a) größer als eine Dicke der Maske (6) ist, wobei das geschmolzene Lot durch einen Veredelungsprozess gereinigt wird;
Bilden der Löthöcker (11) mit der vorbestimmten Dicke durch Entfernen eines Überschusses des geschmolzenen Lots (11a), der über die Dicke der Maske (6) hinaus aufgestapelt wird;
und Entfernen der Maske (6) von dem überlappenden Substrat (1), wobei eine Umgebungstemperatur während der Verarbeitung in sowohl dem Schritt des Aufstapelns des geschmolzenen Lots (11a) als auch dem Schritt des Bildens der Löthöcker (11) durch Entfernen des Überschusses des geschmolzenen Lots (11a) bei einer Temperatur gehalten wird, die den geschmolzenen Zustand des geschmolzenen Lots (11a), wie er ist, beibehalten kann;
wobei der Veredelungsprozess durch Rühren und Mischen des geschmolzenen Lots (11a) mit einer Lösung, die 5 Masse-% bis 25 Masse-% an organischer Fettsäure mit 12 bis 20 Kohlenstoffatomen enthält, und Erhitzen auf eine Temperatur von 180 °C bis 350 °C durchgeführt wird;
wobei das geschmolzene Lot (11a) ein geschmolzenes bleifreies Lot ist, das Zinn als Hauptkomponente und zumindest Nickel als eine Zusatzkomponente beinhaltet, und ferner eine oder mehrere Komponenten ausgewählt aus Silber, Kupfer, Zink, Bismut, Antimon und Germanium als eine optionale Zusatzkomponente beinhaltet, und das Entfernen des Überschusses des geschmolzenen Lots (11a), der über die Dicke der Maske hinaus aufgestapelt wird, durch eine Entfernungseinheit durchgeführt wird, die ausgewählt ist aus einer Gruppe bestehend aus einer Klinge, einem Luftschneider und einer Entfernungseinheit, die eine Lösung, welche eine organische Fettsäure mit 12 bis 20 Kohlenstoffatomen enthält, sprüht.

2. Verfahren zur Bildung von Löthöckern (11) nach Anspruch 1, wobei ein Beschichtungsfilm mit einer organischen Fettsäure in der Lösung, welche die organische Fettsäure enthält, auf den Löthöckern (11) gebildet wird.

3. Verfahren zur Bildung von Löthöckern nach Anspruch 1 oder 2, wobei die eine organische Fettsäure enthaltende Lösung, eine Lösung ist, die Palmitinsäure mit 16 Atomen aufweist.

4. Verfahren zum Herstellen eines Anbringungssubstrats, umfassend:
Bilden von Löthöckern (11) auf einer Oberfläche einer Kupferelektrode (2) durch das Verfahren zur Bildung von Löthöckern (11) nach einem der Ansprüche 1 bis 3; und Anbringen einer elektronischen Komponente auf den gebildeten Löthöckern (11) durch Löten.

## Revendications

1. Procédé de formation de perles de soudure (11), comprenant les étapes consistant à :
préparer un substrat (1) présentant une électrode de cuivre (2) ; attendu que sur l'électrode de cuivre (2), seules sont exposées des portions pour le montage de composants électroniques, tandis que d'autres portions du substrat sont recouvertes d'une couche isolante ou d'un film isolant ;
préparer un masque (5) à partir d'une couche de matériau thermorésistant, la couche étant dotée d'une portion à ouvertures (6), le masque présentant une épaisseur dans une plage allant de 20 à 500 µm, puis à
faire chevaucher le masque (5) et le substrat (1) par une mise en correspondance et superposition de la position de la portion à ouvertures dans le masque avec la position de l'électrode de cuivre ;
empiler une brasure fondue (11a) en pulvérisant un écoulement de jet de la brasure fondue à une température non inférieure à 150 °C et non supérieure à 300 °C, dans lequel le substrat est maintenu dans une position horizontale durant la pulvérisation et l'écoulement de jet de la brasure fondue est pulvérisé par le dessus jusqu'à ce qu'une épaisseur de la brasure fondue (11a) soit supérieure à une épaisseur du masque (6), dans lequel la brasure fondue est purifiée par un processus d'affinage ;
former les perles de soudure (11) présentant l'épaisseur prédéterminée en enlevant un surplus de la brasure fondue (11a) qui est empilée au-delà de l'épaisseur du masque (6), et enlever le masque (6) du substrat présentant un chevauchement (1), dans lequel une température d'atmosphère durant le processus tant à l'étape d'empilement de la brasure fondue (11a) qu'à l'étape de formation des perles de soudure (11) en enlevant le surplus de brasure fondue (11a) est maintenue à une température qui est en mesure de conserver l'état fondu de la brasure fondue (11a) tel quel ;
le processus d'affinage est réalisé en agitant et mélangeant la brasure fondue (11a) avec une solution incluant de 5 % à 25 % en masse d'un acide gras organique et présentant de 12 à 20 atomes de carbone et chauffée à une température allant de 180 °C à 350 °C ;
la brasure fondue (11a) est une brasure fondue sans plomb qui inclut de l'étain comme composant principal et au moins du nickel comme composant accessoire, et inclut en outre un ou plusieurs composants sélectionnés parmi l'argent, le cuivre, le zinc, le bismuth, l'antimoine et le germanium comme composant accessoire optionnel, et l'enlèvement du surplus de la brasure fondue (11a) empilée au-delà de l'épaisseur du masque (6) est réalisé par une unité d'enlèvement, sélectionnée parmi un groupe consistant en une lame, un dispositif de coupe à air et une unité d'enlèvement pulvérisant une solution contenant un acide gras organique présentant de 12 à 20 atomes de carbone.

2. Procédé de formation de perles de soudure (11) selon la revendication 1, dans lequel un film de revêtement présentant un acide gras organique dans la solution contenant un acide gras organique est formé sur les perles de soudure (11).

3. Procédé de formation de perles de soudure selon la revendication 1 ou 2, dans lequel la solution contenant un acide gras organique est une solution incluant de l'acide palmitique présentant 16 atomes.

4. Procédé destiné à fabriquer un substrat de montage, comprenant les étapes consistant à :
former des perles de soudure (11) sur une surface de l'électrode de cuivre (2) par le procédé de formation de perles de soudure (11) selon l'une quelconque des revendications 1 à 3, et à monter un composant électronique par brasure sur les perles de soudure formées (11).
